(19) Europäisches Patentamt

European Patent Office

Office européen des brevets

(11) Veröffentlichungsnummer: **0 223 284 B1**

(12) **EUROPÄISCHE PATENTSCHRIFT**

(45) Veröffentlichungstag der Patentschrift: **24.06.92**

(51) Int. Cl.⁵: **G01R 33/34**, G01R 33/36

(21) Anmeldenummer: **86201904.9**

(22) Anmeldetag: **31.10.86**

(54) **Hochfrequenz-Spulenanordnung für Kernspinresonanzgerät.**

(30) Priorität: **02.11.85 DE 3538952**

(43) Veröffentlichungstag der Anmeldung:
**27.05.87 Patentblatt 87/22**

(45) Bekanntmachung des Hinweises auf die
Patenterteilung:
**24.06.92 Patentblatt 92/26**

(84) Benannte Vertragsstaaten:
**DE FR GB NL**

(56) Entgegenhaltungen:
EP-A- 0 084 946        EP-A- 0 154 360
EP-A- 0 156 042        DE-A- 2 716 636
DE-A- 2 750 589        US-A- 3 795 855

(73) Patentinhaber: **Philips Patentverwaltung
GmbH
Wendenstrasse 35 Postfach 10 51 49
W-2000 Hamburg 1(DE)**

(84) Benannte Vertragsstaaten:
**DE**

(73) Patentinhaber: **N.V. Philips' Gloeilampenfabrieken
Groenewoudseweg 1
NL-5621 BA Eindhoven(NL)**

(84) Benannte Vertragsstaaten:
**FR GB NL**

(72) Erfinder: **Röschmann, Peter
Steenbalken 13
W-2000 Hamburg 63(DE)**

(74) Vertreter: **Hartmann, Heinrich, Dipl.-Ing. et al
Philips Patentverwaltung GmbH Wendenstrasse 35 Postfach 10 51 49
W-2000 Hamburg 1(DE)**

**Beschreibung**

Die Erfindung betrifft eine Hochfrequenz-Spulenanordnung für ein Kernspinresonanzgerät mit einer Leiteranordnung. Derartige Hochfrequenz-Spulenanordnungen sind u.a. aus den europäischen Patentanmeldungen 82107332 und 84201869 bekannt. Sie dienen dazu, ein Hochfrequenz-Magnetfeld in einem Körper zu erzeugen und/oder ein in einem Körper erzeugtes Hochfrequenz-Magnetfeld zu empfangen. Die Hochfrequenz-Spulenanordnung muß dabei auf die sogenannte Larmorfrequenz abgestimmt sein, die der Stärke eines in dem Kernspinresonanzgerät erzeugten homogenen stationären Magnetfeldes proportional ist und die darüber hinaus von der Art der Kerne abhängt, deren Kernspinresonanz beobachtet werden soll. Bei einem Kernspinresonanzgerät mit einem stationären Magnetfeld von 2T liegt diese Frequenz für die am häufigsten untersuchten Wasserstoffprotonen bei rund 85 MHz.

Zur Abstimmung werden bei den bekannten Hochfrequenz-Spulenanordnungen Stellglieder mit einstellbarer Kapazität verwendet - z.B. Drehkondensatoren oder kurzgeschlossene oder offene Leitungsstücke - , die der Hochfrequenz-Spulenanordnung oder Teilen davon parallelgeschaltet sind.

Es ist Aufgabe der vorliegenden Erfindung, eine Hochfrequenzspule zu schaffen, bei der das Nachstimmglied bereits in die Leiteranordnung integriert ist.

Diese Aufgabe wird erfindungsgemäß dadurch gelöst, daß die Leiteranordnung einen ein Dielektrikum umschliessenden Außenleiter mit hohlzylindrischem Querschnitt und mit zwei Koppelöffnungen umfaßt, daß innerhalb des Dielektrikums zwei Innenleiter vorgesehen sind, die lediglich im Bereich der Koppelöffnung zumindest hochfrequenzmäßig miteinander verbunden sind, daß wenigstens einer der beiden Innenleiter verschiebbar ist und daß die Hochfrequenzsignale zwischen dem Außenleiter und einem der Innenleiter so zugeführt bzw. entnommen werden, daß über den Außenleiter und von diesem über zumindest eine der durch einen Innenleiter und den Außenleiter gebildeten Kapazitäten zu dem Innenleiter ein Hochfrequenzstrom fließt.

Die Abstimmung der Hochfrequenz-Spulenanordnung erfolgt dadurch, daß wenigstens einer der verschiebbaren Innenleiter in geeigneter Weise verschoben wird, wobei sich die Kapazität zwischen Innen- und Außenleiter und damit die Resonanzfrequenz der Leiteranordnung ändert. Die Kapazität hängt aber nicht nur von der Stellung der Innenleiter ab, sondern auch von deren Dicke, von dem Innendurchmesser des Außenleiters und von der relativen Dielektrizitätskonstante des Dielektrikums. Durch geeignete Wahl dieser Parameter kann der Abstimmbereich den jeweiligen Erfordernissen angepaßt werden, ohne daß die äußeren Abmessungen der Leiteranordnung geändert werden müßten.

Eine Hochfrequenzspule kann aus mehreren derartiger Leiteranordnungen aufgebaut sein. Auch dabei wird aber die Resonanzfrequenz der Hochfrequenz-Spulenanordnung durch die Resonanzfrequenz der einzelnen Leiteranordnungen bestimmt.

Es gibt verschiedene Möglichkeiten, die beiden Innenleiter zumindest hochfrequenzmäßig miteinander zu verbinden. Eine Möglichkeit besteht darin, daß die beiden Innenleiter aus den die Koppelöffnungen bildenden Enden des Außenleiters herausragen und über einen elektrisch leitenden Schirm miteinander verbunden sind. Der elektrisch leitende Schirm kann dabei aber auch die Innenleiter mehrerer Leiteranordnungen jeweils miteinander verbinden, die in gleicher Richtung vom Hochfrequenzstrom durchflossen werden. Der räumliche Verlauf des Hochfrequenz-Magnetfeldes kann durch die Form des elektrisch leitenden Schirmes, den Abstand der Leiteranordnung(en) vom Schirm und den Abstand der Leiteranordnung(en) voneinander in großem Maße den verschiedesten Anforderungen angepaßt werden.

Es lassen sich auf diese Weise Hochfrequenz-Spulenanordnungen mit sehr hohen Resonanzgüten (typische Werte zwischen 1000 und 1500 bei Verwendung von Kupferrohren für die Außenleiter bzw. Kupferfolien für den Schirm) erreichen. Bei typischen Abständen von etwa 5 cm bis 10 cm zwischen dem Außenleiter bzw. den Außenleitern und dem Schirm ergibt eine derartige Spulenanordnung relativ kleine Induktivitäten und relativ große Kapazitäten. Aus diesem Grund ergeben sich relativ kleine elektrische Feldstärken und damit relativ geringe dielektrische Verluste, wenn der Patient sich im Wirkungsbereich der Spule befindet.

Bei der zuvor erwähnten Ausführungsform erfolgt die hochfrequenzmäßige (und galvanische) Verbindung der Innenleiter über den elektrisch leitenden Schirm. Die Koppelöffnungen der Außenleiter werden dabei in der Regel durch die beiden Enden des Außenleiters gebildet, aus denen die Innenleiter herausragen.

Es ist aber auch möglich, mit einer oder mehreren Leiteranordnungen eine hochfrequenzmäßig geschlossene Stromschleife zu bilden. Eine erste Möglichkeit dazu besteht darin, daß die Leiteranordnung einen vorzugsweise rechteckigen Rahmen bildet, wobei sich die Koppelöffnungen in unmittelbarer Nähe befinden und daß die aus der Koppelöffnung herausragenden Enden der Innenleiter galvanisch miteinander verbunden sind. Hierbei wird also nur eine einzige gebogene oder geknickte Leiteranordnung verwendet. Eine andere Möglichkeit besteht darin, daß die Innenleiter einer ersten Leiteranordnung über die Innenleiter einer zweiten Leiteranordnung miteinander verbunden sind. In diesem Falle besteht zwischen den Enden des Innenleiters einer Leiteranordnung nur eine hochfrequenzmäßige Verbindung.

Die Erfindung wird nachstehend anhand der Zeichnung näher erläutert. Es zeigen:

Fig. 1          eine Leiteranordnung mit einem Schirm in seitlicher Darstellung,

Fig. 2          die gleiche Anordnung in einem Querschnitt senkrecht zur Ausdehnungsrichtung der Leiteranordnung,

Fig. 3          deren Ersatzschaltbild,

Fig. 4a bis 4c  eine Oberflächenspule in drei zueinander senkrechten Ansichten,

Fig. 4d         eine für höhere Frequenzen geeignete Abwandlung dieses Prinzips in der Draufsicht,

Fig. 5          eine Körperspule mit zwei elektrisch leitenden Schirmen,

Fig. 6          eine solche mit vier elektrisch leitenden Schirmen,

Fig. 7 bis 11   verschiedene Spulenanordnungen, die aus einer oder mehreren Leiteranordnungen bestehen.

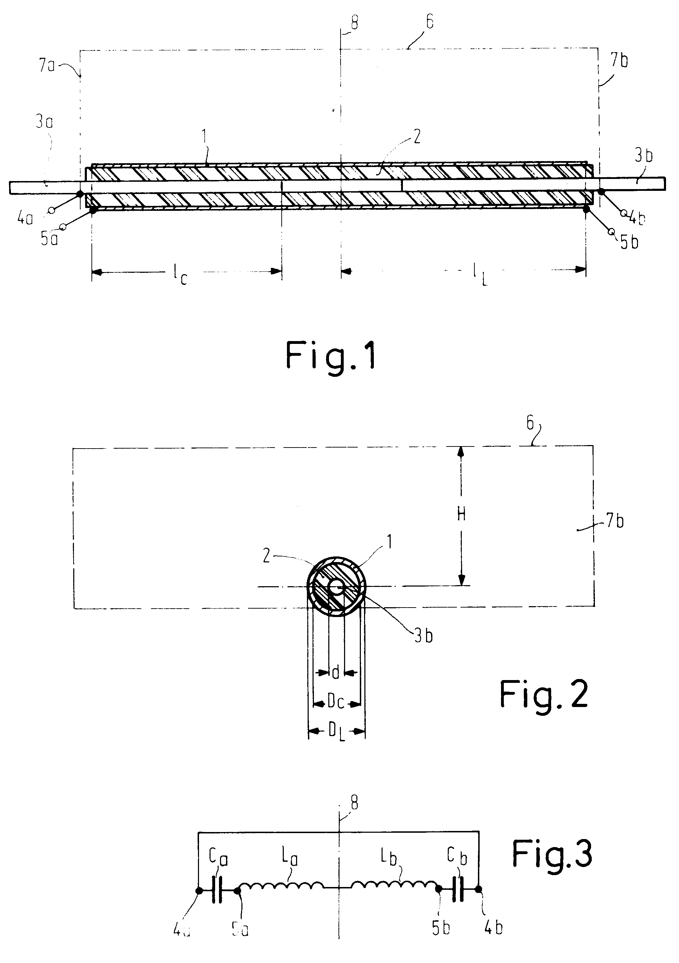

In Fig. 1 und 2 ist mit 1 ein elektrisch leitendes Rohr mit der Länge $2l_L$, dem Außendurchmesser $D_L$ und dem Innendurchmesser $D_c$ bezeichnet. Das Rohr 1 bildet den Außenleiter der Leiteranordnung. Typische Werte für $D_L$ und $D_c$ sind 12 bzw. 10 mm. Im Innern des Rohres befindet sich ein Dielektrikum. Für höhere Resonanzfrequenzen wird ein Dielektrikum mit einer niedrigeren relativen Dielektrizitätskonstante gewählt, z.B. Teflon, und für niedrigere Resonanzfrequenzen wird ein Dielektrikum mit einer höheren Dielektrizitätskonstante gewählt, z.B. Aluminium-Oxyd-Keramik. Das Dielektrikum 2 besitzt in seinem Inneren eine zum Außenleiter 1 konzentrische Bohrung, in der zwei Innenleiter 3a und 3b verschiebbar angeordnet sind, die aus den die Koppelöffnungen darstellenden Enden des Außenleiters 1 herausragen und vorzugsweise gleich tief in den Außenleiter 1 eintauchen, wobei die Eintauchtiefe mit $l_c$ bezeichnet ist. Zusammen mit einer noch zu beschreibenden hochfrequenzmäßigen oder galvanischen Verbindung der herausragenden Enden der Innenleiter 3a und 3b ergibt sich eine Leiteranordnung, aus der - einzeln oder mit mehreren derartiger Leiteranordnungen - eine Hochfrequenz-Spulenanordnung gebildet werden kann.

Bei der Anordnung nach Fig. 1 und 2 wird durch einen elektrisch leitenden Schirm 6 eine galvanische Verbindung zwischen den aus dem Außenleiter 1 herausragenden Enden der Innenleiter 3a und 3b gebildet. Der Schirm 6 erstreckt sich parallel zum Außenleiter 1 im Abstand H vom Zentrum der Leiteranordnung und besitzt zwei Stirnflächen 7a und 7b, die senkrecht zu der Leiteranordnung verlaufen und die über einen nicht näher dargestellten Gleitkontakt elektrisch leitend mit den Enden der Innenleiter 3a und 3b verbunden sind.

In Fig. 3 ist das Ersatzschaltbild der Leiteranordnung dargestellt. Die Anschlußpunkte 4a und 4b werden dabei durch die Verbindungsstelle zwischen den Stirnflächen 7a und 7b des Schirms 6 und der Innenleiter 3a und 3b gebildet, während die Anschlußpunkte 5a und 5b die Enden des Außenleiters bezeichnen (vgl. Fig. 1). Die Kondensatoren $C_a$ bzw. $C_b$ stellen die Kapazitäten zwischen den Innenleitern 3a bzw. 3b und dem Außenleiter 1 dar. Die strichpunktierte Linie 8 in den Fig. 1 und 3 stellt eine geometrische und elektrische Symmetrieebene dar und entspricht einer Kurzschlußebene (Maximum des Hochfrequenzstromes). Die Induktivitäten $L_a$ und $L_b$ ergeben sich zwischen dem Außenleiter und dem Schirm beiderseits der Symmetrieebene.

Die Resonanzfrequenz der Leiteranordnung ergibt sich gemäß

$$f_{res} = 47,75^* \, [\ln(D_c/d)/(\ln(4H/D_L)^*l_L^*l_c^*\epsilon_r)]^{1/2} \qquad (1)$$

in MHz, wenn $l_L$ und $l_c$ in Metern angegeben werden, und $\epsilon_r$ die relative Dielektrizitätskonstante des Dielektrikums 2 ist.

Bei den für Ganzkörperuntersuchungen bei Kernspintomographen typischen Längen der Spulen ($0,25$ m $\leq 2l_L \leq 0,6$ m) ergeben sich mit den innerhalb gewisser Grenzen frei wählbaren Abmessungen $D_L$, $D_c$, d, H und $l_c$ sowie für dielektrische Materialien mit relativen Dielektrizitätskonstanten zwischen 1,5 und 9 Werte der Resonzfrequenz zwischen 20 MHz und 200 MHz (was den Larmorfrequenzen von Wasserstoffprotonen von 0,5 T bis 5 T entspricht). Resonanzfrequenzen zwischen 200 MHz und 600 MHz können mit Hochfrequenz-Spulenanordnungen erreicht werden, bei denen die Länge der Leiteranordnungen zwischen 10 und 20 cm liegt. Die Länge $2l_L$ des Außenleiters sollte dabei stets kleiner sein als eine 1/4 Wellenlänge bei der jeweiligen Resonanzfrequenz (in Luft). Wenn der Hochfrequenzschirm 6 durch eine Kupferfolie gebildet wird und der Außenleiter 6 durch ein Kupferrohr, liegen typische Werte für die Resonanzgüte zwischen 1000 und 1500.

Resonanzfrequenzen unterhalb von 20 MHz für Niedrigfeldsysteme bzw. andere Kerne als Protonen können mit Hilfe von Bariumtitanaten als Dielektrikum verwirklicht werden, deren relative Dielektrizitätskonstante zwischen 20 und 90 liegt. Eine andere Möglichkeit besteht darin, an den Anschlußpunkten 4a, 5a und 4b, 5b verlustarme konzentrierte Kondensatoren parallelzuschalten.

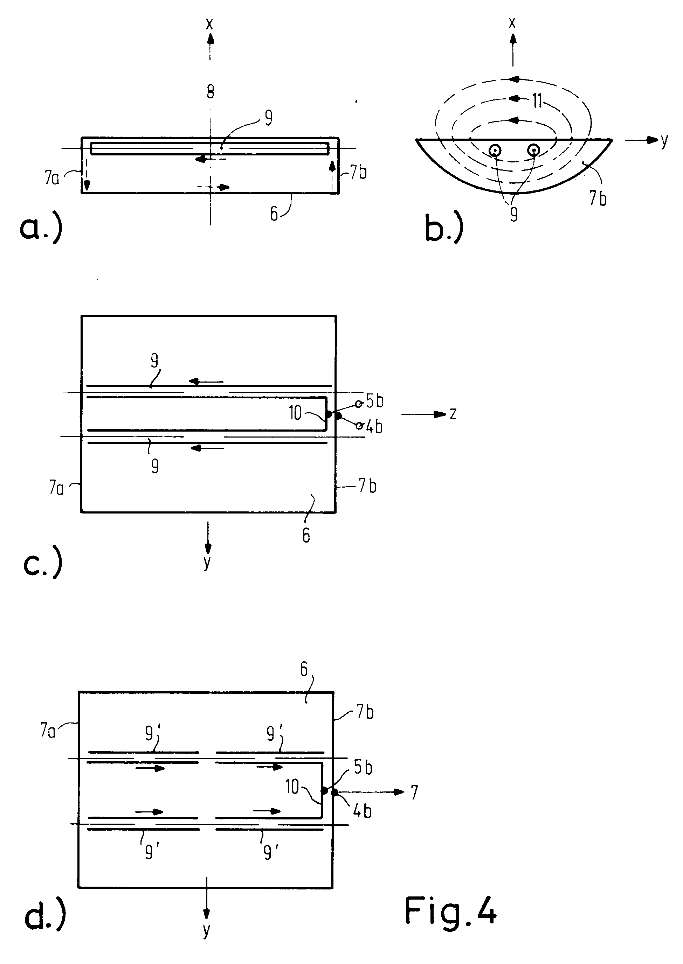

In den Fig. 4a, b und c ist eine nach dem vorstehend geschilderten Prinzip aufgebaute Oberflächenspule dargestellt, und zwar in der Seitenansicht, in einer Frontansicht und in einer Draufsicht. Die Oberflächenspule besteht aus einem elektrischen Schirm 6 und zwei Leiteranordnungen. Die beiden Leiteranordnungen 9 verlaufen in z-Richtung eines kartesischen xyz-Koordinatensystems. Der Schirm, dessen Hauptfläche nicht eben ist, wie bei Fig. 1 und 2, sondern um eine zur z-Achse parallele Achse gekrümmt, verbindet über seine Stirnflächen 7a und 7b die Enden der Innenleiter jeder der beiden Leiteranordnungen. Eine Brücke 10 verbindet die der Stirnfläche 7b zugewandten Enden der beiden Außenleiter und dient gleichzeitig als Anschluß 5b, z.B. über einen nicht dargestellten in Serie geschalteten Anpassungskondensator, an einen Hochfrequenzgenerator bzw. an einen Hochfrequenz-Empfangsverstärker - im allgemeinen über ein Koaxialkabel -, dessen anderer Anschluß (Masse) mit dem Schirm bzw. dem Punkt 4b verbunden ist. Die sich dabei ergebenden Ströme sind in den Fig. 4a und 4c durch Pfeile angedeutet, wobei der über den Hochfrequenzschirm fliessende Strom ein Flächenstrom ist. Fig. 4b zeigt den resultierenden Verlauf der magnetischen Feldlinien 11.

Durch die Anzahl der parallel geschalteten Leiteranordnungen, durch ihre Anordnung innerhalb des Schirms und durch die Form des Schirms läßt sich das Profil des Hochfrequenz-Magnetfeldes den jeweiligen Bedürfnissen entsprechend gestalten. Dabei kann der aus 6 und 7a, 7b gebildete HF-Schirm auch auf Teilbereiche oberhalb der Leiteranordnung 9 ausgedehnt werden, so daß eine zur Symmetrieachse 8 und zur z-Achse vorzugsweise symmetrische Spulenöffnung entsteht, die kleiner als die Projektionsfläche des Schirmes 6 ist. Die Zahl der räumlich und elektrisch parallel geschalteten Leiteranordnungen kann dabei zwischen 1 und 6 liegen. Mit einer Oberflächenspule der in Fig. 4a bis 4c dargestellten Art können bei einem Kernspintomographiegerät große Abbildungsflächen bis 40x50 cm$^2$ in der yz-Ebene erfaßt werden. In der xz- sowie in der xy-Ebene können mit einer derartigen Spule wegen des relativ schwachen Abfalls des (in y-Richtung verlaufenden) Hochfrequenz-Magnetfeldes in x-Richtung Abbildungen bis zu 12 cm Tiefe erreicht werden, wobei das Signal-Rauschverhältnis noch höher liegt als bei einer Ganzkörperspule.

Die in Fig 4d dargestellte Ausführungsform unterscheidet sich von der Ausführungsform nach Fig. 4a bis 4c dadurch, daß jede der beiden Leiteranordnungen 9 durch zwei elektrisch in Serie geschaltete Leiteranordnungen 9' ersetzt ist, wobei die einander zugewandten Innenleiter durch einen einzigen Innenleiter ersetzt sind, der in die Außenleiter beider Leiteranordnungen eintaucht. Die Abstimmung erfolgt dabei durch die aus den Außenleitern herausragenden Enden der jeweils verbleibenden Innenleiter, die mit den Stirnflächen 7a bzw. 7b elektrisch leitend verbunden sind. Die Leiteranordnungen sind dabei also nur halb so lang wie die bei Fig. 4c, so daß sich auch die Induktivitäten halbieren und die bei gleichem Hochfrequenzstrom in der Leiteranordnung auftretenden Hochfrequenzspannungen bzw. elektrischen Feldstärken. Bei körpernahem Betrieb dieser Oberflächenspule sind die dielektrischen Verluste im Betrieb wesentlich geringer.

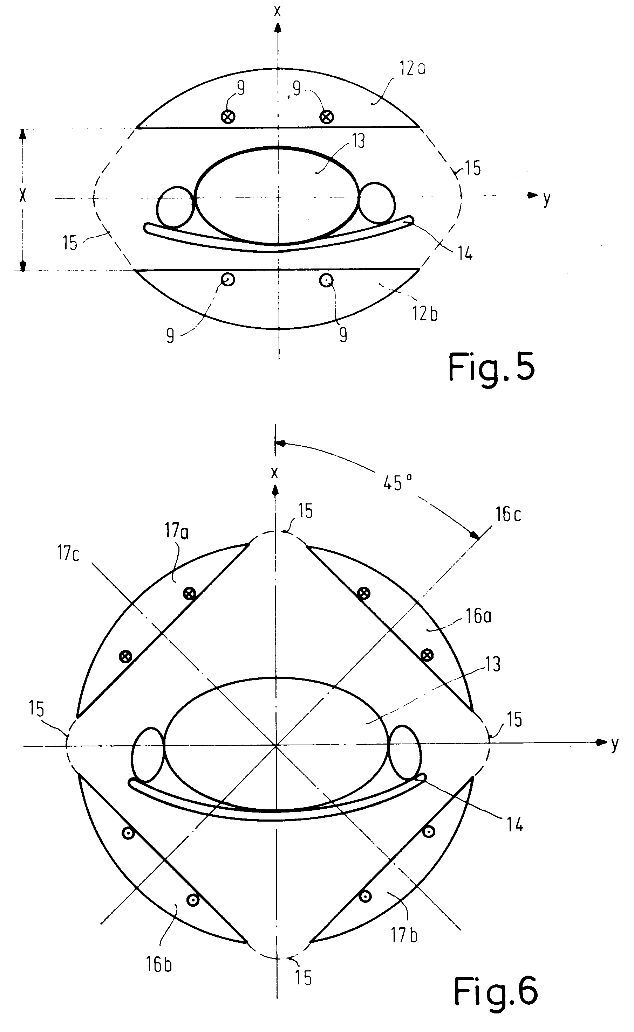

Durch Verwendung mehrerer der in Fig. 4a bis 4c bzw. 4d dargestellten Spulen kann eine den Kopf oder den Körper ganz umschließende Spule gebaut werden, die in einem relativ großen Bereich ein homogenes Hochfrequenz-Magnetfeld erzeugt. Ein erstes Ausführungsbeispiel hierfür zeigt Fig. 5.

Gemäß Fig. 5 sind zwei identisch aufgebaute Teilspulen 12a bzw. 12b gemäß Fig. 4 symmetrisch zur yz-Ebene angeordnet, so daß die Leiteranordnungen 9 in den beiden Teilspulen symmetrisch zur z-Achse angeordnet sind. Die beiden Oberflächenspulen 12a und 12b sind also um die z-Achse um 180° gegeneinander versetzt angeordnet. Dementsprechend werden auch die Leiteranordnungen 9 in den Teilspulen 12a und 12b um 180° gegeneinander versetzt angesteuert, so daß der Strom in der Spule 12a jeweils die entgegengesetzte Richtung hat wie der Strom in der Spule 12b. Diese elektrische Phasenverschiebung kann dadurch erreicht werden, daß die Spannung eines Hochfrequenzgenerators den Klemmen 4b und 5b der Teilspule 12b direkt und den entsprechenden Klemmen der Teilspule 12a über eine Leitung zugeführt werden, deren Länge einer halben Wellenlänge bei der betreffenden Frequenz entspricht.

Durch Verwendung von zusätzlichen Hochfrequenzschirmen 15, die die Schirme der beiden Teilspulen 12a und 12b elektrisch miteinander verbinden, kann die Homogenität des damit erzeugten Hochfrequenzfeldes verbessert und können äußere Störungen besser unterdrückt werden. Wenn die Schirme 15 flexibel sind, kann der Abstand X zwischen den Teilspulen mit Hilfe einer nicht näher dargestellten variablen mechanischen Halterungsvorrichtung der Dicke des jeweiligen Patienten angepaßt werden. Da die Empfindlichkeit der Spule mit kleinerem Abstand X zunimmt, ergibt sich also für den jeweils untersuchten Körperbereich das größtmögliche Signal-Rauschverhältnis.

Die in Fig. 5 dargestellte Hochfrequenz-Spulenanordnung erzeugt ein in y-Richtung verlaufendes magnetisches Feld. Wenn diese Spulenanordnung bezüglich der Tischplatte 14 so - wie in der Zeichnung dargestellt - ausgerichtet ist, daß der Patient mit im allgemeinen ellipsenförmigen Körperquerschnitt lateral von dem in y-Richtung verlaufenden Magnetfeld durchsetzt wird, ergeben sich niedrigere Hochfrequenzverluste und somit höhere Werte der Resonanzgüte als bei einer Ausrichtung des Hochfrequenzfeldes anterior-posterior (d.h. in x-Richtung).

Wie schon in Verbindung mit Fig. 4a bis 4d erläutert, kann die Zahl der Leiteranordnungen 9 in den Teilspulen 12a, 12b größer oder kleiner als 2 sein. Ist die Zahl größer, ergibt sich insbesondere in y-Richtung ein breiterer Homogenitätsbereich des Hochfrequenz-Magnetfeldes.

Die in Fig. 6 dargestellte Hochfrequenz-Spulenanordnung besteht aus vier Teilspulen 16a, 16b, 17a und 17b, die jeweils um 90° bezüglich der z-Achse gegeneinander versetzt sind und deren Leiteranordnungen parallel zur z-Achse verlaufen. Jede dieser Teilspulen hat den in Fig. 4a bzw. 4b dargestellten Aufbau.

Die einander gegenüberliegenden Spulen, z.B. 16a und 16b oder 17a und 17b, werden wie schon in Verbindung mit Fig. 5 erläutert mit um 180° gegeneinander versetzten Spannungen gespeist. Jedoch sind die Spannungen zweier benachbarter Teilspulen, z.B. 16b und 17b, um 90° in der Phase gegeneinander versetzt. Deshalb erzeugt die in Fig. 6 dargestellte Hochfrequenz-Spulenanordnung ein zirkular polarisiertes, d.h. ein um die z-Achse rotierendes, senkrecht zur z-Achse verlaufendes Hochfrequenz-Magnetfeld.

Wie aus der Zeichnung ersichtlich, verlaufen die Symmetrieebenen 16c der Teilspulen 16a und 16b und 17c der Teilspulen 17a und 17b unter einem Winkel von 45° zur Tischplatte 14. Wenn sich der Patient 13 darauf in Bauch- oder Rückenlage befindet, werden die beiden Teilspulensysteme 16a und 16b bzw. 17a und 17b gleichmäßig belastet, so daß die zirkulare Polarisation erhalten bleibt. Wenn die zusätzlichen Hochfrequenzschirme 15, die die Schirme der Teilspulen 16a...17b miteinander verbinden, flexibel sind, kann eine gleichmäßige Belastung auch durch geringes Verkippen oder Verschieben der Teilspulen erreicht werden.

Vorstehend wurde die Erzeugung hochfrequenter Magnetfelder beschrieben, doch können mit derartigen Spulenanordnungen auch hochfrequente Magnetfelder in elektrische Signale umgesetzt werden. Die von den einzelnen Teilspulen erzeugten Signale müssen einander dann mit der angegebenen Phasendrehung überlagert werden.

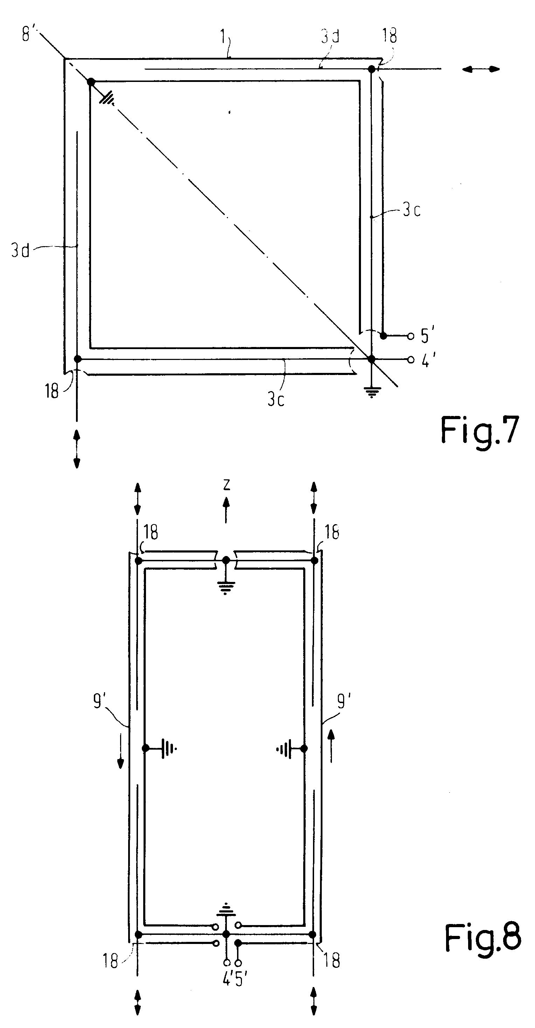

Bei den bisher beschriebenen Hochfrequenz-Spulenanordnungen erfolgte die elektrische Verbindung zwischen den Enden der Innenleiter einer Leiteranordnung durch einen gesonderten Schirm. Diese Verbindung kann aber auch dadurch erreicht werden, daß die Leiteranordnung zu einer runden oder - wie in Fig. 7 dargestellt - rechteckigen Schleife gebogen wird, so daß die Enden des Außenleiters, die die Koppelöffnungen bilden, einander unmittelbar benachbart sind. Die aus diesen Enden herausragenden Enden der Innenleiter sind direkt miteinander verbunden und der Verbindungspunkt 4' sowie das eine Ende 5' des Außenleiters 1 bilden die Anschlußpunkte für den Hochfrequenzgenerator bzw. - bei Verwendung als Empfangsspule - für einen Empfänger, der die in der Spule induzierten Kernspin-Resonanzsignale verarbeitet. Die Innenleiter bestehen in diesem Fall aus einem innerhalb des Außenleiters nicht verschiebbaren Abschnitt 3c und einem innerhalb des Außenleiters 1 bzw. des Dielektrikums verschiebbaren Abschnitt 3d, wobei die beiden Abschnitte über einen Gleitkontakt miteinander verbunden sind. Die Abschnitte 3c befinden sich in den dem Anschlußpunkt 4' benachbarten Schenkein des Außenleiters, während die verschiebbaren Abschnitte 3d in den beiden verbleibenden Schenkeln des Rahmens angeordnet sind. Diese Schenkel sind im Bereich der Gleitkontakte der beiden Innenleiter mit Öffnungen 18 versehen, durch die hindurch die Abschnitte 3d zum zwecke der Abstimmung verschoben werden können.

Ist die Leiteranordnung auf Resonanz abgestimmt, dann bildet die Diagonale 8' des Rahmens eine elektrische und geometrische Symmetrieebene, die einer Kurzschlußebene entspricht und daher mit Masse verbunden werden kann.

In Fig. 8 ist eine Rahmenspule dargestellt, die aus zwei gleichartigen U-förmig geknickten Leiteranordnungen besteht, deren aus den freien Enden herausragende Innenleiter miteinander verbunden sind. Einer der Verbindungspunkte 4' bildet zusammen mit dem benachbarten Ende einer der beiden Leiteranordnungen 5' den Anschluß für einen Hochfrequenzgenerator bzw. Empfänger. Die Innenleiter jeder der beiden Leiteranordnungen bestehen wiederum aus einem festen und einem verschiebbaren Abschnitt, die über einen Gleitkontakt miteinander verbunden sind, und die den verschiebbaren Abschnitt tragenden Schenkel sind im Bereich der Gleitkontakte wiederum mit Öffnungen 18 versehen, durch die hindurch diese Abschnitte in Pfeilrichtung, d.h. in Richtung der Schenkel, verschoben werden können.

Der Vorteil eines derart zusammengesetzten Rahmens gegenüber dem in Fig. 7 dargestellten Rahmen besteht in verringerten dieelektrischen Verlusten bei Betrieb als Oberflächenspule.

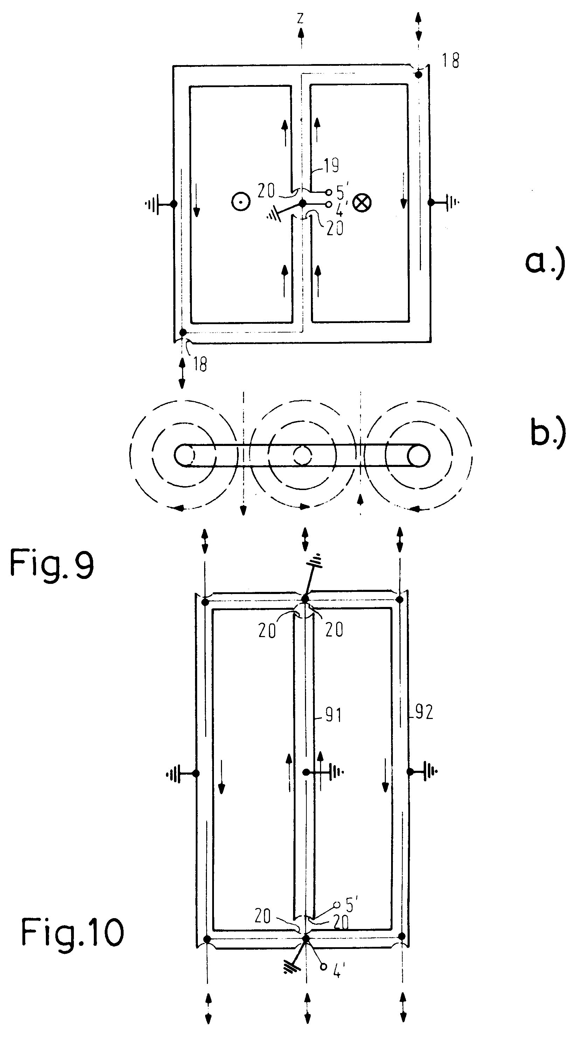

Fig. 9a,b zeigt wiederum eine durch eine einzige Leiteranordnung gebildete Spule, die jedoch durch einen Mittelschenkel 19 in zwei gleich große Hälften unterteilt ist, so daß sich ein Doppelrahmen ergibt. Die Koppelöffnungen 20 befinden sich hierbei in der Mitte des Mittelschenkels 19, wobei der Verbindungspunkt der aus den Koppelöffnungen herausragenden Innenleiterenden den einen Anschluß 4' und das eine Ende des Außenleiters des Mittelschenkels 19 den anderen Anschluß 5' für einen Hochfrequenzgenerator bilden. Dadurch werden in den beiden Rahmenhälften Ströme mit entgegengesetztem Umlaufsinn erzeugt bzw. Magnetfelder, die auf der Ebene des Doppelrahmens senkrecht stehen und einander entgegengerichtet sind. Die Innenleiter bestehen wiederum aus einem innerhalb des Außenleiters nicht verschiebbaren Abschnitt und einem damit über einen Gleitkontakt verbundenen beweglichen Abschnitt, der durch Öffnungen 18 im Bereich des beweglichen Abschnittes verschoben werden kann. Die von den beiden Spulenhälften erzeugten einander entgegengerichteten Magnetfelder kompensieren sich in größerem Abstand von der Spulenebene. Das resultierende Magnetfeld ist daher räumlich auf einen engen Bereich um die Spule begrenzt. Daraus ergibt sich eine geringere Bedämpfung der Spulenresonanz durch Hochfrequenzverluste im Körpergewebe und ein besseres Signal-Rauschverhältnis bei Verwendung des Rahmens als Oberflächenspule zum Empfang von Kernspinresonanzsignalen.

Ein weiterer Vorteil dieser Spule zeigt sich, wenn sie dazu benutzt wird, Kernspinresonanzsignale aufzunehmen, die durch das homogene hochfrequente Magnetfeld einer Sendespule angeregt werden. Dann erweist sich als Vorteil, daß sich die dadurch in den beiden Hälften der Empfangsspule induzierten Signale kompensieren, so daß die Empfangsspule stets von der Sendespule entkoppelt ist.

Die in Fig. 10 dargestellte Hochfrequenzspule bildet ebenfalls einen Doppelrahmen, jedoch besteht sie aus zwei Leiteranordnungen. Die eine Leiteranordnung 91 bildet den Mittelschenkel, während die andere rechteckig abgewinkelte Leiteranordnung 92 den Rahmen bildet, der im Bereich der Enden des Mittelschenkels mit Koppelöffnungen 20 versehen ist. Dort sind die Innenleiter der den Mittelschenkel bildenden Leiteranordnung 91 mit den Innenleitern der den Rahmen bildenden Leiteranordnung 92 verbunden. Einer der beiden Verbindungspunkte 4' und das benachbarte Ende 5' des Außenleiters der Leiteranordnung 91 dienen der Zuführung bzw. zur Entnahme der Hochfrequenzsignale. Bei Abstimmung auf Resonanz ergeben sich in der Mitte des mittleren Schenkels 91 und in der Mitte der Schenkel der Leiteranordnung 92 Strommaxima, so daß diese Punkte geerdet werden können.

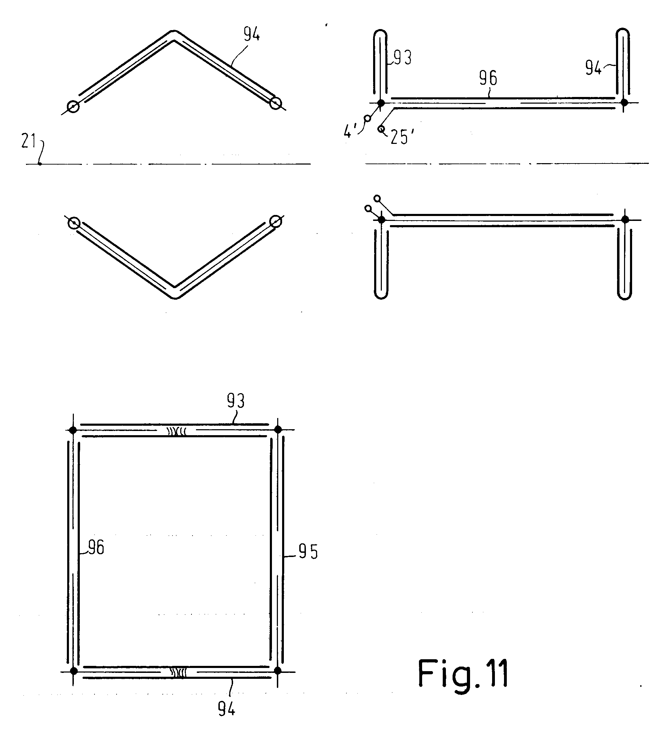

Das in Fig. 11 in Frontansicht, Seitenansicht und Draufsicht dargestellte Ausführungsbeispiel zeigt, daß aus den Leiteranordnungen auch eine Sattelspule nachgebildet werden kann. Die Sattelspule besteht aus zwei identisch aufgebauten und zu einer Ebene 21 symmetrisch angeordneten Hälften. Jede Hälfte setzt sich aus vier Leiteranordnungen zusammen. Die beiden Leiteranordnungen 95, 96 sind geradlinig, gleich lang und parallel zueinander und zur Symmetrieebene 21 angeordnet. Die Leiteranordnungen 93 und 94 sind ebenfalls miteinander identisch, sind jedoch in der Mitte geknickt. Die aus ihnen herausragenden Innenleiterenden sind mit den Innenleiterenden der Schenkel 95 und 96 verbunden, so daß die daraus gebildete Spulenhälfte den Konturen eines Satteldaches ähnelt. Die Zuführung bzw. Entnahme von Hochfrequenzsignalen erfolgt wiederum zwischen einem der Verbindungspunkte 4' der Innenleiter und dem benachbarten Ende des Außenleiters 5'. Die Speisung der unteren Spulenhälfte erfolgt an der gleichen Stelle, so daß der Hochfrequenzstrom durch die Schenkel 95 und 96 der oberen Spulenhälfte und durch die ihnen symmetrisch zur Ebene 21 zugeordneten Schenkel der unteren Spulenhälfte jeweils in der gleichen Richtung fließt.

Wenn jede der Leiteranordnungen auf die gleiche Resonanzfrequenz abgestimmt ist, ergeben sich Strommaxima jeweils in der Mitte der Außenleiter sowie an allen Verbindungspunkten (entsprechend 4') der aus den Außenleitern herausragenden Innenleiter. Diese Punkte können daher geerdet werden. Aufgrund der vielen Massepunkte einer derart aufgebauten Sattelspule ergeben sich im Innenbereich der Spule relativ geringe elektrische Feldstärken und damit relativ geringe dielektrische Verluste.

Um eine Spulenanordnung, die aus mehreren Leiteranordnungen aufgebaut ist, wie beispielsweise die nach Fig. 5, 6 oder 11, betreiben zu können, müssen alle Leiteranordnungen auf die gleiche Resonanzfrequenz abgestimmt sein. Wenn damit eine Kernspinresonanzuntersuchung vorgenommen werden soll und ein Patient sich in der Nähe der Spulenanordnung befindet, ergibt sich eine geringe Verstimmung. Diese Verstimmung kann jedoch durch Nachstimmen nur einer der Leiteranordnungen beseitigt werden.

**Patentansprüche**

1. Hochfrequenz-Spulenanordnung für Kernspinresonanzgerät mit einer Leiteranordnung, dadurch gekennzeichnet, daß die Leiteranordnung einen ein Dielektrikum (2) umschliessenden Außenleiter (1) mit hohlzylindrischem Querschnitt und mit zwei Koppelöffnungen umfaßt, daß innerhalb des Dielektrikums (2) zwei Innenleiter (3a, 3b) vorgesehen sind, die lediglich im Bereich der Koppelöffnung zumindest hochfrequenzmäßig miteinander verbunden sind, daß wenigstens einer der beiden Innenleiter (3a, 3b) verschiebbar ist und daß die Hochfrequenzsignale zwischen dem Außenleiter und einem der Innenleiter (3a bzw. 3b) so zugeführt bzw. entnommen werden, daß über den Außenleiter (1) und von diesem über zumindest eine der durch einen Innenleiter (3a bzw. 3b) und den Außenleiter (1) gebildeten Kapazitäten (Ca bzw. Cb) zu dem Innenleiter ein Hochfrequenzstrom fließt.

2. Hochfrequenz-Spulenanordnung nach Anspruch 1,
dadurch gekennzeichnet, daß die beiden Innenleiter (3a, 3b) aus den die Koppelöffnungen bildenden Enden des Außenleiters (1) herausragen und über einen elektrisch leitenden Schirm (6) miteinander verbunden sind.

3. Hochfrequenz-Spulenanordnung nach Anspruch 2,
dadurch gekennzeichnet, daß mehrere Leiteranordnungen (9, 9') über ihre Innenleiter elektrisch in Serie geschaltet sind und daß die voneinander abgewandten Innenleiter der beiden äußeren Leiteranordnungen über einen elektrisch leitenden Schirm (6) miteinander verbunden sind.

4. Hochfrequenz-Spulenanordnung nach Anspruch 2 oder 3,
dadurch gekennzeichnet, daß mehrere Leiteranordnungen 9) über den gleichen Hochfrequenzschirm (6) elektrisch parallelgeschaltet sind.

5. Hochfrequenz-Spulenanordnung nach einem der Ansprüche 2 bis 4,
dadurch gekennzeichnet, daß die Leiteranordnung(en) (9) geradlinig und parallel zu einer Seitenfläche des Schirms (6) verlaufen und daß die Enden der Innenleiter mit senkrecht dazu verlaufenden Stirnflächen (7a, 7b) des Schirms elektrisch leitend verbunden sind.

6. Hochfrequenz-Spulenanordnung nach Anspruch 5,
dadurch gekennzeichnet, daß eine gerade Anzahl von Schirmen (12a,12b) mit den zugehörigen Leiteranordnungen (9) paarweise symmetrisch zu einer parallel zur Richtung der Leiteranordnungen verlaufenden Achse angeordnet sind.

7. Hochfrequenz-Spulenanordnung nach Anspruch 1,
dadurch gekennzeichnet, daß die Leiteranordnung (1) einen vorzugsweise rechteckigen Rahmen bildet, wobei sich die Koppelöffnungen einander unmittelbarer benachbart und daß die aus der Koppelöffnung herausragenden Enden der Innenleiter (3c) galvanisch miteinander verbunden sind.

8. Hochfrequenz-Spulenanordnung nach Anspruch 1,
dadurch gekennzeichnet, daß die Innenleiter einer ersten Leiteranordnung (9') über die Innenleiter einer zweiten Leiteranordnung miteinander verbunden sind.

9. Hochfrequenz-Spulenanordnung nach Anspruch 8,
dadurch gekennzeichnet, daß die beiden Leiteranordnungen einen vorzugsweise rechteckigen Rahmen bilden.

10. Hochfrequenz-Spulenanordnung nach Anspruch 7 bis 9,
dadurch gekennzeichnet, daß durch Ausbildung eines Mittelschenkels (91) ein symmetrischer Doppelrahmen gebildet wird, wobei die Ströme in den Außenleitern der Teilrahmen entgegengesetzten Umlaufsinn aufweisen.

11. Hochfrequenz-Spulenanordnung nach Anspruch 1,
dadurch gekennzeichnet, daß die Leiteranordnungen (93,94) geknickt sind.

12. Hochfrequenz-Spulenanordnung nach Anspruch 7 bis 11,
dadurch gekennzeichnet, daß die Innenleiter aus zwei Abschnitten (3c, 3d) bestehen, von denen der eine (3c) fest im Dielektrikum angeordnet ist und der andere damit leitend verbundene Abschnitt (3d) innerhalb des Dielektrikums verschiebbar ist.

**Claims**

1. A high-frequency coil system for a nuclear spin resonance apparatus, comprising a system of conductors, characterized in that the system of conductors includes an outer conductor (1) which encloses a dielectric (2) and which has a hollow-cylindrical cross-section and two coupling apertures, inside the dielectric (2) there being arranged two inner conductors (3a, 3b) which are interconnected at least for high-frequency only at the area of the coupling aperture, at least one of the two inner conductors (3a, 3b) being displaceable, the high-frequency signals being applied and derived between the outer conductor and one of the inner conductors (3a or 3b) so that a high-frequency current will flow *via* the outer conductor (1) and therefrom, *via* at least one of the capacitances (Ca or Cb) formed by an inner conductor (3a or 3b) and the outer conductor (1), to the inner conductor.

2.   A high-frequency coil system as claimed in Claim 1, characterized in that the two inner conductors (3a, 3b) project from the ends of the outer conductor (1) which form the coupling apertures and are interconnected *via* an electrically conductive shield (6).

3.   A high-frequency coil system as claimed in Claim 2, characterized in that a plurality of systems of conductors (9, 9') are electricallly connected in series by way of their inner conductors, the non-facing inner conductors of the two outer systems of conductors being interconnected *via* an electrically conductive shield.

4.   A high-frequency coil system as claimed in Claim 2 or 3, characterized in that a plurality of systems of conductors (9) are connected electrically in parallel *via* the same high-frequency shield (6).

5.   A high-frequency coil system as claimed in any one of the Claims 2 to 4, characterized in that the system (systems) of conductors (9) extends (extend) linearly and parallel to a side face of the shield (6), the ends of the inner conductors being electrically conductively connected to end faces (7a, 7b) of the shield which extend perpendicularly thereto.

6.   A high-frequency coil system as claimed in Claim 5, characterized in that an even number of shields (12a, 12b), with the associated systems of conductors (9), are arranged pair-wise symmetrically with respect to an axis extending parallel to the direction of the systems of conductors.

7.   A high-frequency coil system as claimed in Claim 1, characterized in that the system of conductors (1) forms a preferably rectangular frame, the coupling apertures being situated in the immediate vicinity of one another, the ends of the inner conductors (3c) projecting from the coupling apertures being conductively interconnected.

8.   A high-frequency coil system as claimed in Claim 1, characterized in that the inner conductors of a first system of conductors (9') are interconnected *via* the inner conductors of a second system of conductors.

9.   A high-frequency coil system as claimed in Claim 8, characterized in that the two systems of conductors form a preferably rectangular frame.

10.  A high-frequency coil system as claimed in the Claims 7 to 9, characterized in that a symmetrical double frame is formed by the formation of a central leg (91), the currents in the outer conductors of the sub-frames flowing in opposite directions.

11.  A high-frequency coil system as claimed in Claim 1, characterized in that the systems of conductors (93, 94) are bent.

12.  A high-frequency coil system as claimed in the Claims 7 to 11, characterized in that the inner conductor consists of two sections (3c, 3d), one of which (3c) is fixed in the dielectric whilst the other section (3d) which is conductively connected thereto is displaceable inside the dielectric.

## Revendications

1.   Montage de bobines haute fréquence pour un appareil de résonance magnétique nucléaire comportant un montage de conducteurs, caractérisé en ce que le montage de conducteurs comporte un conducteur extérieur (1) de section cylindrique creuse entourant un diélectrique (2) et présentant deux ouvertures de couplage, qu'à l'intérieur du diélectrique (2) sont prévus deux conducteurs intérieurs (3a, 3b) qui ne sont connectés que dans la zone de l'ouverture de couplage au moins en haute fréquence l'un à l'autre, qu'au moins l'un des deux conducteurs intérieurs (3a, 3b) est coulissant et que les signaux de haute fréquence sont appliqués ou pris entre le conducteur extérieur (1) et l'un des conducteurs intérieurs (3a, 3b) de manière telle qu'un courant de haut fréquence passe par le conducteur extérieur (1) et, à partir de celui-ci, par au moins l'une des capacités (Ca ou Cb) formées par un conducteur intérieur (3a ou 3b) et le conducteur extérieur (1), au conducteur intérieur.

2.   Montage de bobines haute fréquence suivant la revendication 1, caractérisé en ce que les deux conducteurs intérieurs (3a, 3b) dépassent des extrémités du conducteur extérieur (1) formant les ouvertures de couplage et sont connectés l'un à l'autre par l'intermédiaire d'un écran conducteur électrique (6).

**3.** Montage de bobines haute fréquence suivant la revendication 2, caractérisé en ce que plusieurs montages de conducteurs (9, 9') sont montés électriquement en série par l'intermédiaire de leurs conducteurs intérieurs et que les conducteurs intérieurs, éloignés l'un de l'autre, des deux montages de conducteurs extérieurs sont connectés l'un à l'autre par l'intermédiaire d'un écran électriquement conducteur (6).

**4.** Montage de bobines haute fréquence suivant la revendication 2 ou 3, caractérisé en ce que plusieurs montages de conducteurs (9) sont connectés électriquement en parallèle par l'intermédiaire du même écran de haute fréquence (6).

**5.** Montage de bobines haute fréquence suivant l'une quelconque des revendications 2 à 4, caractérisé en ce que le ou les montages de conducteurs (9) sont rectilignes et s'étendent parallèlement à une face latérale de l'écran (6) et que les extrémités des conducteurs intérieurs sont connectées de manière conductrice électrique aux faces d'about (7a, 7b) de l'écran qui y sont perpendiculaires.

**6.** Montage de bobines haute fréquence suivant la revendication 5, caractérisé en ce qu'un nombre pair d'écrans (12a, 12b) avec les montages de conducteurs (9) associés sont disposés par paires symétriquement par rapport à un axe s'étendant parallèlement au sens des montages de conducteurs.

**7.** Montage de bobines haute fréquence suivant la revendication 1, caractérisé en ce que le montage de conducteurs (1) forme un cadre de préférence rectangulaire, les ouvertures de couplage étant immédiatement voisines l'une de l'autre et que les extrémités des conducteurs intérieurs (3c) faisant saillie hors de l'ouverture de couplage sont connectées l'une à l'autre par voie galvanique.

**8.** Montage de bobines haute fréquence suivant la revendication 1, caractérisé en ce que les conducteurs intérieurs d'un premier montage de conducteurs (9') sont reliés l'un à l'autre par l'intermédiaire des conducteurs intérieurs d'un second montage de conducteurs.

**9.** Montage de bobines haute fréquence suivant la revendication 8, caractérisé en ce que les deux montages de conducteurs forment un cadre qui est de préférence rectangulaire.

**10.** Montage de bobines haute fréquence suivant les revendications 7 à 9, caractérisé en ce que, par la formation d'une branche médiane (91), on obtient un cadre double symétrique dans lequel les courants passant dans les conducteurs extérieurs des cadres partiels sont de sens opposés.

**11.** Montage de bobines haute fréquence suivant la revendication 1, caractérisé en ce que les montages de conducteurs (93, 94) sont coudés.

**12.** Montage de bobines haute fréquence suivant les revendications 7 à 11, caractérisé en ce que les conducteurs intérieurs sont constitués de deux sections (3c, 3d) dont l'une, (3c), est montée fixe dans le diélectrique et l'autre, (3d), qui y est reliée de manière conductrice est déplaçable à l'intérieur du diélectrique.

# Fig.1

# Fig.2

# Fig.3

Fig.4

Fig.5

Fig.6

Fig.7

Fig.8

a.)

b.)

Fig.9

Fig.10

# Fig.11